# EUROPEAN PATENT SPECIFICATION

(11) **EP 2 940 528 B1**
(45) Date of publication and mention of the grant of the patent: **16.11.2016**
(21) Application number: 15165648.5
(22) Date of filing: 29.04.2015
(51) Int. Cl.: G03F 7/20, H01L 23/06, B32B 15/04, B32B 15/08, B32B 15/20, B32B 3/02, B32B 3/30, C23C 18/16, C23C 18/18, H01Q 1/22

(54) **METHOD OF FABRICATING SUBSTRATE STRUCTURE AND SUBSTRATE STRUCTURE FABRICATED BY THE SAME METHOD**
VERFAHREN ZUR HERSTELLUNG EINER SUBSTRATSTRUKTUR UND AUF DIESE WEISE HERGESTELLTE SUBSTRATSTRUKTUR
PROCÉDÉ DE FABRICATION DE STRUCTURE DE SUBSTRAT ET STRUCTURE DE SUBSTRAT FABRIQUÉ À L'AIDE DE CE PROCÉDÉ

(30) Priority: 30.04.2014 US 201414265369
(43) Date of publication of application: 04.11.2015
(73) Proprietor: Wistron NeWeb Corp., Hsinchu 308 (TW)
(72) Inventor: Radi, Babak, Hsinchu 308 (TW); Chen, Shih-Hong, Hsinchu 308 (TW); Kuo, Yu-Fu, Hsinchu 308 (TW); Chen, Chun-Lin, Hsinchu 308 (TW); Chen, Jing-Wen, Hsinchu 308 (TW)
(74) Representative: Chamberlain, Alan James

(56) References cited:
- EP-A2- 0 480 703
- WO-A1-99/08317
- JP-A- H05 226 055
- US-A1- 2006 046 495
- US-A1- 2009 314 650
- LOVE J C ET AL: "SELF-ASSEMBLED MONOLAYERS OF THIOLATES ON METALS AS A FORM OF NANOTECHNOLOGY", CHEMICAL REVIEWS, AMERICAN CHEMICAL SOCIETY, US, vol. 105, no. 4, 13 April 2005 (2005-04-13), pages 1103-1169, XP002349570, ISSN: 0009-2665, DOI: 10.1021/CR0300789 [retrieved on 2005-03-25]

## Description

### TECHNICAL FIELD

The present disclosure is directed to a method of fabricating a substrate structure and a substrate structure fabricated by the same method.

### BACKGROUND

Conventionally, in order to form structures on a substrate by using a process that minimizes manual machining, such process may involve techniques such as photolithography, electroplating, etching, and so forth. Photolithography has been a reliable method used to form structural patterns on a substrate, and a process of using photolithography during fabrication to pattern parts of a substance deposited on a substrate would typically involve one or more photo masks having a specific geometric pattern which would be transferred from a photo mask to a light-sensitive photoresist. After a period of exposure to light, chemical or high intensity photon treatments would be performed to remove a part of the light-sensitive photoresist to develop a patterned exposure into which a material could then be deposited on the material underneath the photo resist.

However, such process would involve numerous expensive machines and masks as well as extremely clean operating conditions so that the overall costs of manufacturing would be increased. Also, in order to secure a photoresist onto a substrate, a polymeric resin such as epoxy would need to be sprayed on parts on a bonding surface before curing. Such process would involve additional chemicals and extra steps. Furthermore, even though electroplating has been a popular process used to deposit material into exposed parts of a photo resist on the material underneath the photo resist, conventional electroplating would also incur costs because of the use of electroplating equipment, electrodes, plating solutions, and etc.

For instance, JP H05 226055 discloses a method for making a substrate comprising a base metal layer on which an insulation film is deposited. Throughholes are formed in the insulation layer by laser etching. On the back surface of the base metal layer another resist layer is formed. A second metal layer is deposited in the holes laser etched into the insulation film in the form of bumps.

Worth mentioning is the review of J. Ch. Love et al. in Chem. Rev. 2005, 105, 1103-1169 about self-assembled monolayers of thiolates on metal surfaces like Au, Ag, and others. Patterning and using said monolayers as etch resists or for making metal-molecule junctions is discussed in the article.

WO 99/08317 discloses an electric circuit comprising a metal layer provided with a passivation layer made of a monomolecular film of alkylthiolates; said layer may be patterned by exposure to UV radiation through a mask.

Therefore, there could be a more efficient and cost effective way of developing patterned structures on a substrate than above mentioned conventional practices.

### SUMMARY OF THE DISCLOSURE

The present disclosure is directed to a method of fabricating a substrate structure and a substrate structure fabricated by the same method.

According to an exemplary embodiment, the method of fabricating a substrate structure includes the steps of forming a first metal layer directly on a base, forming a second metal layer directly on the first metal layer, forming a first protective layer by using a compound comprising a thiol group directly on the second metal layer, patterning the first protective layer to form at least one opening exposing the second metal layer, and forming a third metal layer within the at least one opening and directly on the second metal layer.

In one of the exemplary embodiment, the present disclosure is directed to a substrate structure which includes at least, but not limited to, a base, a first metal layer disposed on the base, a second metal layer disposed on the first metal layer, a first protective layer comprising a thiol compound and disposed on the second metal layer, at least one opening disposed in the first protective layer and exposing the second metal layer, and a third metal layer disposed within the at least one opening and is disposed on the second metal layer.

In order to make the aforementioned features and advantages of the present disclosure comprehensible, exemplary embodiments accompanied with figures are described in detail below. It is to be understood that both the foregoing general description and the following detailed description are exemplary, and are intended to provide further explanation of the disclosure as claimed.

It should be understood, however, that this summary may not contain all of the aspect and embodiments of the present disclosure and is therefore not meant to be limiting or restrictive in any manner. Also the present disclosure would include improvements and modifications which are obvious to one skilled in the art.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1A illustrates a first step of fabricating a substrate structure in accordance with an exemplary embodiment of the present disclosure.
FIG. 1B illustrates forming a first metal layer on a base in accordance with an exemplary embodiment of the present disclosure.
FIG. 1C illustrates forming a second metal layer on the first metal layer in accordance with an exemplary embodiment of the present disclosure.
FIG. 1D illustrates forming a first protective layer on the second metal layer in accordance with an exemplary embodiment of the present disclosure.
FIG. 1E illustrates patterning the first protective layer in accordance with an exemplary embodiment of the present disclosure.
FIG. 1F illustrates forming the third metal layer in accordance with an exemplary embodiment of the present disclosure.
FIG. 2 illustrates a process of fabricating the substrate structure in accordance with an exemplary embodiment of the present disclosure.

### DETAILED DESCRIPTION OF DISCLOSED EMBODIMENTS

Reference will now be made in detail to the present exemplary embodiments of the disclosure, examples of which are illustrated in the accompanying drawings. Wherever possible, the same reference numbers are used in the drawings and the description to refer to the same or like parts.

The present disclosure proposes a method of fabricating a patterned metal layer structure onto a substrate by using a combination of chemical and laser treatment. The substrate is made of, for example, metal; and in an embodiment of the present disclosure, the metal used for the substrate could be nickel. Under conventional methods, fixtures, equipment, and masks are typically required to cover an area that should not be exposed so as to prevent forming a pattern agent. However, the proposed method does not require masks and associated fixtures and equipment for forming a patterned protective layer. In the proposed method, a protective layer is made of a chemical compound, and at least one opening could be formed in the protective layer, in which the at least one opening can be formed and cleaned by laser, such that the patterned protective layer is formed.

The patterned protective layer as aforementioned could be formed by a chemical compound known as thiol or a thiol derivative. The thiol compound may have several variants such as Octadecanethiol, Nonanethiol, 1-Hexadecanethiol, 1-Butanethiol, tert-Nonyl mercaptan, Benzyl mercaptan, and Thiophenol. The patterned protective layer could be formed with one or a combination of such variants. The chemical solution that includes thiol or a thiol derivative as aforementioned is referred to as a thiol compound in the present disclosure.

In one of the exemplary embodiment, the chemical compound that forms the patterned protective layer could be mostly the thiol compound having some non-reactive elements and impurities. The thiol compound is highly flexible during mass production and does not require curing and further processes after curing as required by resins. The thiol compound is laser-able or laser sensitive such that the thiol compound could easily be removed and cleaned by a laser treatment. Also the thiol compound may adhere well to a subsequent layer such as a diffusion barrier layer between metal substrate and metallization solution. For example, the thiol compounds would chemically bind very well with nickel which not only servers as a diffusion barrier layer prevents of metals adhered to the nickel layer but also would prevent oxidation of the nickel layer. Therefore, by applying a general 2D or 3D laser to a chemical protective layer that includes the thiol compound, complex patterns could be developed in the chemical protective layer by forming at least one opening in the chemical protective layer, so that a metal layer could be disposed into the at least one opening of the chemical protective layer by an electroless plating. Such technique would enable a very high rate of production as well as high resolution assuming that a high resolution laser with small spot size is used.

By using the proposed method, a substrate structure could be developed. The substrate structure would include at least, but not limited to, a base, a first metal layer, a second metal layer, a first protective layer, at least one opening, and a third metal layer. A first metal layer would be disposed on the base. The second metal layer would be disposed on the first metal layer to serve as a diffusion barrier layer and a protective layer. The first protective layer would be made of the thiol compound. By performing a laser etching process, at least one opening could be formed in the first protective layer. In other words, the first protective layer could be patterned and include one or more openings. A third metal layer could be disposed into the at least one opening to be adhered to the second metal layer. The third metal layer could be disposed into the at least one opening via an electroless bath. The substrate structure could be used for a variety of mechanical or electrical structures such as a connector, an antenna, and so forth. However, the substrate structure of present disclosure is not limited to any specific application as the substrate structure could be used for any structures and any applications which require a metal pattern formed on a substrate.

The proposed method of the present disclosure would have the following advantages. First, the proposed method could form a metal layer having any complex structure or geometry via a laser etching process. Second, all the required equipment, fixture, and electroless bath could easily be obtained in a low cost manner to perform the proposed process which could also be automated for mass production. Third, the proposed method provides a fast production as compared with the conventional method involving photolithography and electroplating. Fourth, the patterned metal layer is only disposed in the at least one opening of the first protective layer, thus a considerable amount of saving could be accomplished. Fifth, it is no longer needed to spray polymeric resin, such as an epoxy, on the second metal layer before curing because the first protective layer could be disposed on the second metal layer by immersion into a solution including the thiol compound. Sixth, when the thiol compound is used as mold to form the patterned metal layer, the dimension of the mold and the subsequently deposited layers would not change because of the formation of the mono-layers of thiol; whereas when a technique involving an application of resin is used, the thickness of the mold would get bigger. Consequently, the changing dimension of the mold and the patterned metal layer could be problematic when the substrate is assembled with other parts.

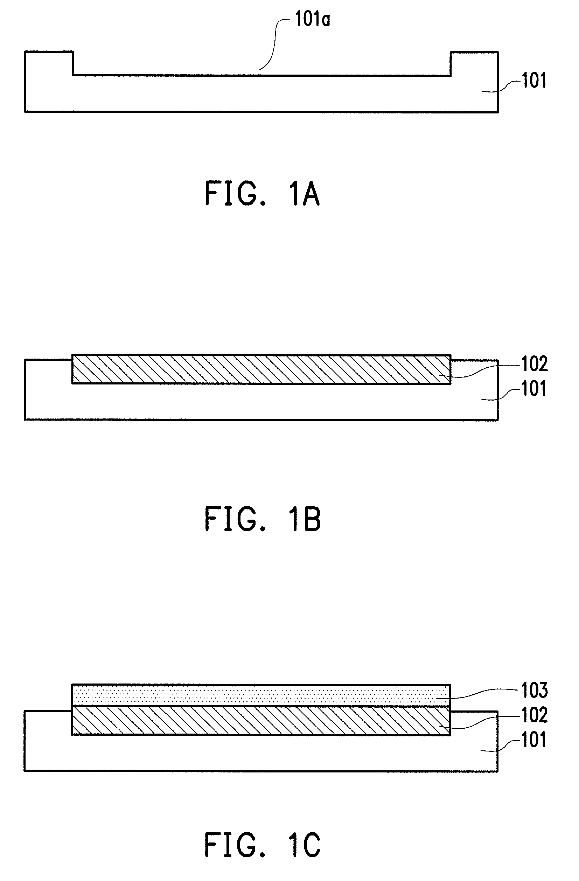

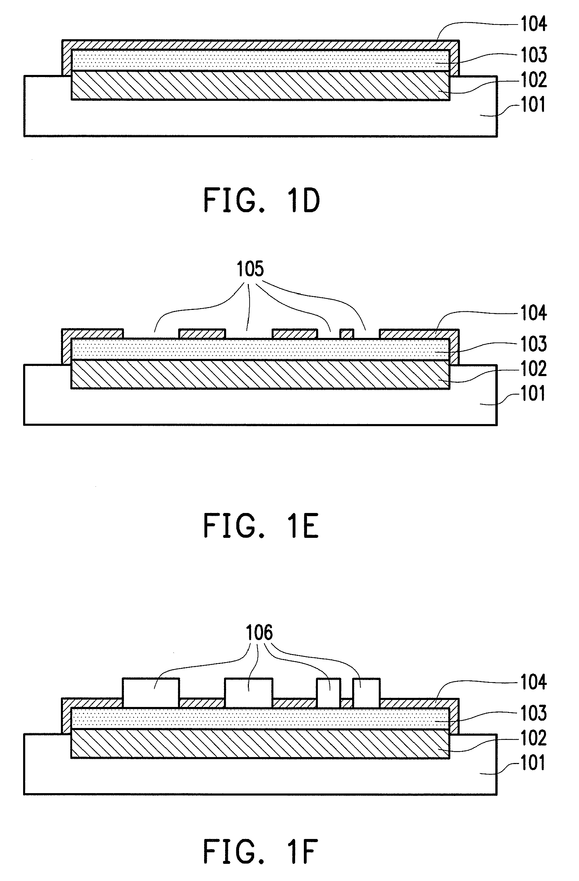

An exemplary embodiment is provided by FIG. 1A∼ FIG. 1F and the corresponding written descriptions of these figures in order to further elucidate the proposed concept. Referring to FIG. 1A, a substrate or a base 101 could be used as a foundation and as a part of a substrate structure. The base 101 could be rigid or flexible. The base 101 is, for example, made of polymer; however, the present disclosure is not limited to. In other embodiments of the present disclosure, any metal or non-metal materials could be used as the material of the base 101 as long as the base 101 is capable of providing adequate stability for the substrate structure and for a subsequent layer to adhere onto. Also according to FIG. 1A, a recess portion 101a is formed in the base 101 by a laser etching, in which a part of the base 101 is removed, as such a next metal layer could be disposed into the recess portion 101 a. However, the formation of the recess portion 101a is optional since the next metal layer could also be disposed on a surface of the base 101 without the recess portion 101a.

Next, a first metal layer 102 could be formed on a surface of the recess portion 101a of the base 101 as illustrated by FIG. 1B. In the embodiment of the present disclosure, a recess portion 101a is formed in the base 101 by the laser etching, and the first metal layer 102, which could be made of copper for example, is then disposed on the surface of the recess portion 101a of the base 101 by electroplating. For example, the proposed substrate structure is to be used as an antenna, where the first metal layer 102 could be copper which serves as a ground for the antenna. However, the use of copper is merely exemplary and should not be construed as a limitation for the present disclosure. The first metal layer 102 could also be made of, for example, gold, silver, or nickel.

FIG. 1C illustrates the formation of a second metal layer 103 disposed on the first metal layer 102 in accordance with an exemplary embodiment of the present disclosure. Since another metallic layer would eventually be formed as a last metal layer having a pattern, the second metal layer 103 would be require to prevent potential diffusion between the first metal layer 102 and the last metal layer. Also the second metal layer 103 would prevent oxidation of the surfaces of the first metal layer 102. Therefore, in the embodiment of the present disclosure, the second metal layer 103 is disposed onto the first metal layer 102 by an electroless plating. However, a conventional technique, such as electroplating or sputtering, could also be used as long as the second metal layer 103 could adhere to the first metal layer 102. The second metal layer 103 could be nickel which would serve as an excellent diffusion barrier between two metal layers; however, the second metal layer 103 could also be silver or any other materials as long as the materials used as the second metal layer 103 could serve as a diffusion barrier and prevent oxidation of the metal layers.

Subsequent to the formation of the second metal layer 103, a first protective layer 104 is disposed on the second metal layer 103 as illustrated by FIG. 1D. The first protective layer 104 is formed by coating a liquid solution on the second metal layer 103, in which the liquid solution includes the thiol or thiol derivative. For one embodiment, the first protective layer 104 is formed by a dip coating which the second metal layer 103 is inserted and removed from a bath of the liquid solution. If the second metal layer 103 is a nickel layer, the liquid solution including the thiol compound would adhere well to nickel. The first protective layer 104 would be securely disposed onto the second metal layer 103 by placing the uncured first protective layer 104 in a room temperature, or placing the first protective layer 104 in an oven to expedite the curing process. The first protective layer 104 as proposed in the present disclosure would not require an additional step of spraying a polymeric resin, such as an epoxy. The first protective layer 104 would serve as a mask, barrier or cover to prevent the last metal layer from being disposed on un-intended locations of the second metal layer 103 after the first protective layer 104 is patterned.

FIG. 1E illustrates patterning the first protective layer 104 after the first protective layer 104 has been securely disposed on the second metal layer 103 in accordance with an exemplary embodiment of the present disclosure. Since the thiol compound is sensitive to laser, a general laser process could be performed to pattern the first protective layer 104, which at least a portion of the first protective layer 104 is removed, and at least one opening 105 is formed. That is, the first protective layer 104 may includes the at least one opening 105, and which the last metal layer could be disposed into the at least one opening 105 and further be adhered to the second metal layer 103. This process step in FIG. IE could be utilized to replace a process step of photolithography. In this process step, a laser bean is applied to the first protective layer 104, which etches away at least a portion of the first protective layer 104, thereby forming the at least one opening 105. The above proposed process step would not require any masks and fixtures to pattern the first protective layer 104 for forming the at least one opening 105.

After the at least one opening 105 is formed in the first protective layer 104, FIG. 1F illustrates a formation of the third metal layer 106 in accordance with an exemplary embodiment of the present disclosure. The third metal layer 106 is formed by disposing a metal layer into the at least one opening 105. In the embodiment of the present disclosure, the third metal layer 106 is disposed in the at least one opening 105 and is located on the second metal layer 103 by an electroless plating. The third metal layer 106 is, for example, gold. However, the material of the third metal layer 106 could be, for example, copper, silver, or any other highly conductive metal.

The substrate structure fabricated by the proposed method includes a base 101, a first metal layer 102 disposed on the base 101, a second metal layer 103 disposed on the first metal layer 102, a first protective layer 104 made of a chemical solution including a thiol compound and disposed on the second metal layer 103, at least one opening 105 disposed in the first protective layer 104 and exposing the second metal layer 103, and a third metal layer 106 disposed on the second metal layer 103. The first protective layer 104 includes at least one opening 105 exposing the second metal layer 103. The third metal layer 106 is disposed into the at least one opening 105 and is disposed on the second metal layer 103.

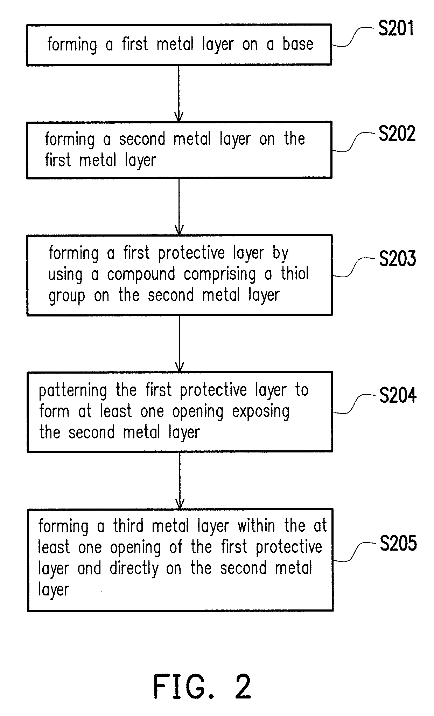

FIG. 2 is a flow chart which summarizes the process of fabricating the substrate structure in accordance with an exemplary embodiment of the present disclosure. In step S201, a first metal layer is formed on a base. In step S202, a second metal layer is formed on the first metal layer. In step S203, a first protective layer is formed by using a chemical solution including a thiol group on the second metal layer. In step S204, the first protective layer is patterned to form at least one opening exposing the second metal layer. In step S205, a third metal layer is formed within the at least one opening of the first protective layer and is formed directly on the second metal layer.

No element, act, or instruction used in the detailed description of disclosed embodiments of the present application should be construed as absolutely critical or essential to the present disclosure unless explicitly described as such. Also, as used herein, each of the indefinite articles "a" and "an" could include more than one item. If only one item is intended, the terms "a single" or similar languages would be used. Furthermore, the terms "any of" followed by a listing of a plurality of items and/or a plurality of categories of items, as used herein, are intended to include "any of', "any combination of", "any multiple of", and/or "any combination of multiples of the items and/or the categories of items, individually or in conjunction with other items and/or other categories of items. Further, as used herein, the term "set" is intended to include any number of items, including zero. Further, as used herein, the term "number" is intended to include any number, including zero.

## Claims

1. A method of fabricating a substrate structure comprising:
(S201) forming a first metal layer (102) directly on a base (101);
(S202) forming a second metal layer (103) directly on the first metal layer (102);
(S203) forming a first protective layer (104) by using a compound comprising a thiol group directly on the second metal layer (103);
(S204) patterning the first protective layer (104) by laser etching to form at least one opening (105) exposing the second metal layer (103); and
(S205) forming a third metal layer (106) within the at least one opening (105) of the first protective layer (104) and directly on the second metal layer (103).

2. The method of claim 1, wherein the compound is selected from a group of Octadecanethiol, Nonanethiol, 1-Hexadecanethiol, 1-Butanethiol, tert-Nonyl mercaptan, Benzyl mercaptan, and Thiophenol.

3. The method of claim 1, wherein the step (S201) of forming the first metal layer (102) located directly on the base (101) comprises:
using a laser to form a recess portion (101a) in the base (101); and
disposing the first metal layer (102) within the recess portion (101a).

4. The method of claim 1, wherein the step (S203) of forming the first protective layer (104) comprises:
coating a solution of the compound on the second metal layer (103).

5. The method of claim 1, wherein the first metal layer (102) is copper or aluminium.

6. The method of claim 1, wherein the second metal layer (103) is a diffusion barrier layer which prevents diffusion between the first metal layer (102) and the third metal layer (106) and prevents oxidation of the first metal layer (102); wherein the second metal layer (103) is nickel or silver..

7. The method of claim 1, wherein the step (S201) of forming the first metal layer (102) comprises forming the first metal layer (102) directly on the base (101) by an electroless plating.

8. The method of claim 1, wherein the step (S205) of forming the third metal layer (106) comprises forming the third metal layer (106) directly on the second metal layer (103) by an electroless plating.

9. A substrate structure comprising:
a base (101);
a first metal layer (102) disposed on the base (101);
a second metal layer (103) disposed on the first metal layer (102);
a first protective layer (104) made of a thiol compound and disposed on the second metal layer (103) and having at least one opening (105) exposing the second metal layer (103); and
a third metal layer (106) disposed within the at least one opening (105) and is disposed on the second metal layer (103).

10. The substrate structure of claim 9, wherein the thiol compound is Octadecanethiol.

11. The substrate structure of claim 9, wherein the thiol compound is selected from a group of Nonanethiol, 1-Hexadecanethiol, 1-Butanethiol, tert-Nonyl mercaptan, Benzyl mercaptan, and Thiophenol.

12. The substrate structure of claim 9, wherein the first metal layer (102) is copper or aluminium.

13. The substrate structure of claim 9, wherein the second metal layer (103) is nickel, silver or chromium.

14. The substrate structure of claim 9, wherein the base (101) is polymer.

15. The substrate structure of claim 9, wherein the third metal layer (106) is gold.

## Patentansprüche

1. Eine Methode zur Herstellung einer Substratstruktur ermöglicht durch:
(S201) die Bildung einer ersten Metallschicht (102) direkt auf einer Basis (101);
(S202) die Bildung einer zweiten Metallschicht (103) direkt auf der ersten Metallschicht (102) gelagert;
(S203) die Bildung einer ersten Schutzschicht (104) mittels Verwendung einer Verbindung bestehend aus einer Thiolgruppe welche direkt auf der zweiten Metallschicht (103) gelagert ist;
(S204) die Gestaltung der ersten Schutzschicht (104) durch Laserätzung zum Zweck der Erstellung von mindestens einer Öffnung (105) zur Freilegung der zweiten Metallschicht (103); und
(S205) die Bildung einer dritten Metallschicht (106) innerhalb mindestens einer Öffnung (105) in der ersten Schutzschicht (104) und direkt auf der zweiten Metallschicht (103).

2. Die Methode gemäß Anspruch 1, wobei die Verbindung aus einer Gruppe von Oktadekanethiol, Nenanethiol, 1-Hexadekanethiol, 1-Butanethiol, tert-Nonyl, Merkaptan, Benzyl-Merkaptan und Thiophenol ausgewählt wird.

3. Die Methode gemäß Anspruch 1, wobei der Schritt (S201) zur Bildung der ersten direkt auf der Basis gelagerten Metallschicht (101) folgendes einschließt:
Verwendung eines Lasers zur Bildung der Aussparung (101 a) in der Basis (101); und
Lagerung der ersten Metallschicht (102) innerhalb der Aussparung (101 a).

4. Die Methode gemäß Anspruch 1, wobei der Schritt (S203) zur Bildung der ersten Schutzschicht (104) folgendes einschließt:
Die Beschichtung der zweiten Metallschicht (103) mit einer Lösung der Verbindung.

5. Die Methode gemäß Anspruch 1, wobei die erste Metallschicht (102) aus Kupfer oder Aluminium besteht.

6. Die Methode gemäß Anspruch 1, wobei die zweite Metallschicht (103) als Diffusionssperre-Schicht dient und damit Diffusion zwischen der ersten Metallschicht (102) und dritten Metallschicht (106) sowie Oxidation der ersten Metallschicht (102) verhindert, wobei die zweite Metallschicht (103) aus Nickel oder Silber besteht.

7. Die Methode gemäß Anspruch 1, wobei der Schritt (S201) zur Bildung der ersten Metallschicht (102) darin besteht daß diese vorerwähnte erste Metallschicht (102) direkt auf der Basis (101) durch stromlose Galvanotechnik gebildet wird.

8. Die Methode gemäß Anspruch 1, wobei der Schritt (S205) zur Bildung der dritten Metallschicht (106) darin besteht daß diese vorerwähnte dritte Metallschicht (106) direkt auf der zweiten Metallschicht (103) durch stromlose Galvanotechnik gebildet wird.

9. Eine Substratstruktur bestehend aus:
einer Basis (101);
eine erste auf der Basis (101) gelagerte Metallschicht (102);
eine zweite Metallschicht (103) gelagert auf der ersten Metallschicht (102);
eine erste aus einer Thiol-Verbindung bestehende Schutzschicht (104) welche auf der zweiten Metallschicht (103) gelagert ist und mindestens eine Öffnung (105) zur Freilegung der zweiten Metallschicht (103) hat; und
eine dritte, innerhalb der mindestens einen Öffnung (105) gelagerte Metallschicht (106) welche auf der zweiten Metallschicht (103) gelagert ist.

10. Die Substratstruktur gemäß Anspruch 9, wobei die Thiol-Verbindung aus Oktadekanethiol besteht.

11. Die Substratstruktur gemäß Anspruch 9, wobei die Thiol-Verbindung von einer Gruppe bestehend aus Nonanethiol, 1-Hexadekanethiol, 1-Butanethiol, tert-Nonyl-Merkaptan, Benzyl-Merkaptan und Thiophenol ausgewählt wird.

12. Die Substratstruktur gemäß Anspruch 9, wobei die erste Metallschicht (102) aus Kupfer oder Aluminium besteht.

13. Die Substratstruktur gemäß Anspruch 9, wobei die zweite Metallschicht (103) aus Nickel, Silber oder Chrome besteht.

14. Die Substratstruktur gemäß Anspruch 9, wobei die Basis (101) aus Polymer besteht.

15. Die Substratstruktur gemäß Anspruch 9, wobei die dritte Metallschicht (106) aus Gold besteht.

## Revendications

1. Un procédé de fabrication d'une structure de substrat consistant à :
(S201) former une première couche métallique (102) directement sur une base (101) ;
(S202) former une deuxième couche métallique (103) directement sur la première couche métallique (102) ;
(S203) former une première couche de protection (104) à l'aide d'un composé comprenant un groupe thiol directement sur la deuxième couche métallique (103) ;
(S204) définir la forme de la première couche de protection (104) par gravure au laser pour former au moins une ouverture (105) révélant la deuxième couche métallique (103) ; et
(S205) former une troisième couche métallique (106) à l'intérieur de la ou des ouvertures (105) de la première couche de protection (104) et directement sur la deuxième couche métallique (103).

2. Le procédé de la revendication 1, dans lequel le composé est sélectionné parmi un groupe d'octadécane thiol, de nonane thiol, de 1-hexadécane thiol, de 1-butane thiol, de tert-nonyl mercaptan, de benzyl mercaptan et de thiophénol.

3. Le procédé de la revendication 1, dans lequel l'étape (S201) de formation de la première couche métallique (102) située directement sur la base (101) consiste à:
utiliser un laser pour former une partie d'évidement (101 a) dans la base (101) ;
et disposer la première couche métallique (102) à l'intérieur de la partie d'évidement (101 a).

4. Le procédé de la revendication 1, dans lequel l'étape (S203) de formation de la première couche de protection (104) consiste à :
étaler une solution du composé sur la deuxième couche métallique (103).

5. Le procédé de la revendication 1, dans lequel la première couche métallique (102) est du cuivre ou de l'aluminium.

6. Le procédé de la revendication 1, dans lequel la deuxième couche métallique (103) est une barrière de diffusion qui empêche la diffusion entre la première couche métallique (102) et la troisième couche métallique (106) et empêche l'oxydation de la première couche métallique (102) ; dans lequel la deuxième couche métallique (103) est du nickel ou de l'argent.

7. Le procédé de la revendication 1, dans lequel l'étape (S201) de formation de la première couche métallique (102) consiste à former la première couche métallique (102) directement sur la base (101) par un dépôt autocatalytique.

8. Le procédé de la revendication 1, dans lequel l'étape (S205) de formation de la troisième couche métallique (106) comprend la formation de la troisième couche métallique (106) directement sur la deuxième couche métallique (103) par un dépôt autocatalytique.

9. Une structure de substrat consistant en :
une base (101) ;
une première couche métallique (102) disposée sur la base (101) ;
une deuxième couche métallique (103) disposée sur la première couche métallique (102) ;
une première couche de protection (104) faite d'un composé thiol et disposée sur la deuxième couche métallique (103) et présentant au moins une ouverture (105) révélant la deuxième couche métallique (103) ; et
une troisième couche métallique (106) à l'intérieur de la ou des ouvertures (105) disposée sur la deuxième couche métallique (103).

10. La structure de substrat de la revendication 9, dans laquelle le composé thiol est octadécane thiol.

11. La structure de substrat de la revendication 9, dans laquelle le composé de thiol est sélectionné parmi un groupe de nonane thiol, de 1-hexadécane thiol, de 1-butane thiol, de tert-nonyl mercaptan, de benzyl mercaptan et de thiophénol.

12. La structure de substrat de la revendication 9, dans laquelle la première couche métallique (102) est du cuivre ou de l'aluminium.

13. La structure de substrat de la revendication 9, dans laquelle la deuxième couche métallique (103) est du nickel, de l'argent ou du chrome.

14. La structure de substrat de la revendication 9, dans laquelle la base (101) est un polymère.

15. La structure de substrat de la revendication 9, dans laquelle la troisième couche métallique (106) est de l'or.
